(19) **Europäisches Patentamt / European Patent Office / Office européen des brevets**

(11) **EP 4 122 100 B1**

(12) **EUROPÄISCHE PATENTSCHRIFT**

(45) Veröffentlichungstag und Bekanntmachung des Hinweises auf die Patenterteilung:
**27.08.2025  Patentblatt 2025/35**

(21) Anmeldenummer: **21712784.4**

(22) Anmeldetag: **15.03.2021**

(51) Internationale Patentklassifikation (IPC):
**H03K 17/955** (2006.01)

(52) Gemeinsame Patentklassifikation (CPC):
**H03K 17/955;** H03K 2217/960705;
H03K 2217/960725

(86) Internationale Anmeldenummer:
**PCT/EP2021/056560**

(87) Internationale Veröffentlichungsnummer:
**WO 2021/185776 (23.09.2021 Gazette 2021/38)**

(54) **KAPAZITIVER NÄHERUNGSSENSOR**

CAPACITIVE PROXIMITY SENSOR

CAPTEUR DE PROXIMITÉ CAPACITIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.03.2020  DE 102020107704**

(43) Veröffentlichungstag der Anmeldung:
**25.01.2023  Patentblatt 2023/04**

(73) Patentinhaber: **Pepperl+Fuchs SE**
**68307 Mannheim (DE)**

(72) Erfinder: **VÖLKEL, Hardi**
**68519 Viernheim (DE)**

(74) Vertreter: **Banse & Steglich**
**Patentanwälte PartmbB**
**Patentanwaltskanzlei**
**Herzog-Heinrich-Straße 23**
**80336 München (DE)**

(56) Entgegenhaltungen:
EP-A1- 0 226 082     EP-A1- 2 642 663
EP-A2- 0 908 736     EP-B1- 0 226 082
EP-B1- 2 642 663

**Beschreibung**

Technisches Gebiet

Die Erfindung betrifft kapazitive Näherungssensoren mit einer Messkapazität, die insbesondere durch zyklisches Laden und Entladen mithilfe eines Umschalters gemessen wird.

Technischer Hintergrund

Kapazitive Näherungssensoren weisen eine elektrisch leitende Sonde auf. Zwischen der Sonde und einem zu detektierenden Objekt stellt sich eine Messkapazität abhängig von einer Entfernung zwischen der Sonde und dem Objekt ein. Zur Vereinfachung wird das Objekt als leitfähig und geerdet angenommen. Die sich mit der Entfernung des Objekts von der Sonde einstellende Messkapazität kann gemessen werden, um eine Angabe über eine Entfernung des Objekts zu erhalten.

Bei einem kapazitiven Näherungsschalter findet zudem ein Schwellwertvergleich mit dem Ausgang des Näherungssensors statt, bei dem ein Zustand eines Schaltausgangs des Näherungsschalters das Vorhandensein oder Nichtvorhandensein des Objekts innerhalb eines Bereichs um die Sonde angibt.

Kapazitive Näherungssensoren werden häufig in einem Switched Capacitor-Betrieb betrieben, bei dem die Messkapazität zyklisch über einen Schalter auf ein definiertes Spannungspotenzial aufgeladen wird und danach zu einem weiteren Spannungspotenzial entladen wird. Der Lade- und/oder der Entladestrom wird als ein Maß für die Größe der Messkapazität angenommen. Mithilfe eines Wandlers kann der Lade- und/oder Entladestrom in eine Messspannung gewandelt werden.

Für das Umschalten zwischen Ladung und Entladung der Messkapazität ist ein Schalter als Bauteil notwendig, der in der Regel als integriertes Bauteil, als ein sogenannter Analogschalter, realisiert wird. Jedoch besitzen derartige aktive, schaltende Bauelemente parasitäre Kapazitäten zwischen den Schaltkontakten und den Versorgungsspannungsanschlüssen. Somit wird beim Umladen der Messkapazität eine parasitäre Kapazität ebenfalls geladen, so dass Lade- und Entladestrom sich erhöhen. Dadurch nimmt die Empfindlichkeit des Näherungssensors ab, da die parallel zur Messkapazität angeordnete parasitäre Kapazität die Gesamtkapazität deutlich erhöht, jedoch die Empfindlichkeit der Änderung der Gesamtkapazität bezüglich einer Abstandsänderung des zu detektierenden Objekts abnimmt.

Die Druckschrift EP 0 226 082 A1 offenbart eine Kapazitätsmessschaltung mit einer Umschaltanordnung, welche die Messkapazität mit einer vorgegebenen Umschaltfrequenz periodisch abwechselnd zur Aufladung an eine konstante Spannung legt und zur Entladung mit einem Speicherkondensator verbindet, dessen Kapazität groß gegen die Messkapazität ist und dessen Klemmenspannung durch einen kontrollierten Entladestrom im Wesentlichen auf einem konstanten Bezugspotential gehalten wird, wobei die Größe des Entladestroms der Messkapazität proportional ist und den Messwert darstellt, wobei eine weitere Umschaltanordnung vorgesehen ist, welche eine der Messkapazität zugeordnete Abschirmung mit der Umschaltfrequenz periodisch abwechselnd an Potentiale legt, die im Wesentlichen der konstanten Spannung bzw. dem Bezugspotential entsprechen.

Die Druckschrift EP 2 642 663 A1 offenbart einen Sensor zum Nachweisen eines Objekts mit einer Sondenelektrode zum Bilden einer Messkapazität mit dem nachzuweisenden Objekt, mit einem Ladegenerator zum Erzeugen einer alternierenden Ladespannung, wobei die Sondenelektrode mittels der alternierenden Ladespannung geladen wird, mit einem Verstärker zum Verstärken einer Spannung über der Messkapazität, wobei der Verstärker einen ersten Versorgungsanschluss und einen zweiten Versorgungsanschluss aufweist, mit Elektronikmitteln zum Verarbeiten von Signalen, die an einem Ausgang des Verstärkers ausgegeben werden, zu mindestens einem Ausgangssignal und mit mindestens einem Sensorausgang zum Ausgeben des mindestens einen Ausgangssignals, wobei an dem zweiten Versorgungsanschluss als eine zweite Versorgungsspannung eine Gleichspannung anschließbar ist und wobei an dem ersten Versorgungsanschluss eine erste Versorgungsspannung mit einem Wechselspannungsanteil anschließbar ist.

Die Druckschrift EP 0 908 736 A2 offenbart eine Schaltungsanordnung zur Erfassung der Kapazität bzw. einer Kapazitätsänderung eines kapazitiven Schaltungs- oder Bauelementes, mit einem Taktgenerator, einem von dem Taktgenerator gesteuerten Umschaltkontakt, einem Speicherkondensator, einer Spannungsquelle und einer Auswertestufe, bei der eine Elektrode des kapazitiven Schaltungs- oder Bauelementes mit dem Eingang des Umschaltkontaktes verbunden ist. Der erste Ausgang des Umschaltkontaktes ist mit der ersten Elektrode des Speicherkondensators, die erste Elektrode des Speicherkondensators ist einerseits über ein Widerstandsnetzwerk mit der Spannungsquelle und andererseits mit der Auswertestufe verbunden. Die zweite Elektrode des Speicherkondensators ist mit einem Bezugspotential verbunden sind, wobei die Auswertestufe für Stromauswertung geeignet ist und am Umschaltkontakt somit quasi kein Spannungshub auftritt.

Es ist daher Aufgabe, einen auf Switched Capacitor-Betrieb ausgebildeten Näherungssensor möglichst unabhängig von den Einflüssen parasitärer Kapazitäten zu betreiben und insbesondere die Empfindlichkeit eines Näherungssensors bezüglich der Messkapazität zu erhöhen.

Offenbarung der Erfindung

Diese Aufgabe wird durch den kapazitiven Näherungssensor gemäß Anspruch 1 gelöst.

Weitere Ausgestaltungen sind in den abhängigen Ansprüchen angegeben.

Gemäß einem ersten Aspekt ist ein kapazitiver Näherungssensor zur Detektion eines Objekts innerhalb eines Erfassungsbereichs und zum Bereitstellen einer Sensorausgangsspannung vorgesehen, umfassend:

- eine elektrisch leitfähige Sonde;
- eine Ladeschaltung und/oder eine Entladeschaltung zum zyklischen Laden einer sich an der Sonde einstellenden Messkapazität während einer Ladephase auf ein Ladepotenzial bzw. zum Entladen der sich an der Sonde einstellenden Messkapazität während einer Entladephase auf ein Entladepotenzial, wobei die Ladeschaltung und/oder die Entladeschaltung ausgebildet sind, um eine insbesondere erste Ausgangsspannung abhängig von einem Ladestrom in die Messkapazität und/oder eine insbesondere zweite Ausgangsspannung abhängig von einem Entladestrom aus der Messkapazität bereitzustellen, wobei die Sensorausgangsspannung abhängig von der bzw. den Ausgangsspannungen, insbesondere der ersten und/oder der zweiten Ausgangsspannung, bereitgestellt wird;
- eine aktive Umschalteinrichtung zum wechselweisen elektrischen Verbinden der Sonde mit der Ladeschaltung und der Entladeschaltung;
- eine Schalterversorgungsspannungsquelle, die ausgebildet ist, um Schalterversorgungspotenziale zur elektrischen Versorgung der aktiven Umschalteinrichtung synchron zum Umschalten zwischen der Ladephase und Entladephase zyklisch umzuschalten.

Eine übliche Ausgestaltung zum Realisieren des Switched Capacitor-Betriebs besteht darin, das Umschalten der Messkapazität zwischen einer Ladephase und eine Entladephase mithilfe einer aktiven Umschalteinrichtung, insbesondere in Form eines Analogschalters, auszuführen. Analogschalter sind integrierte Bausteine, die einen Steuereingang aufweisen, der bewirkt, dass ein Eingangsanschluss mit einem von zwei Ausgangsanschlüssen, abhängig von einem Pegel am Steueranschluss, verbunden wird. Derartige Analogschalter realisieren ihre Funktion mithilfe von Transistoren, insbesondere Feldeffekttransistoren, und benötigen zu deren Betrieb eine Versorgungsspannung.

Durch den Einsatz eines Analogschalters ist die Messsonde neben der Eingangsimpedanz eines nachfolgenden Verstärkers auch mit parasitären Kapazitäten im Analogschalter verbunden. Ein wesentlicher Anteil der parasitären Kapazitäten liegt dabei zwischen dem niedrigen bzw. hohen Versorgungspotential des Analogschalters und dem Eingangsanschluss des Analogschalters an, mit dem die Messkapazität verbunden ist. Weitere parasitäre Kapazitäten liegen zwischen dem niedrigen bzw. hohen Versorgungspotential des Analogschalters und den Ausgangsanschlüssen des Analogschalters an.

Diese parasitären Kapazitäten verringern die Sensitivität des Näherungssensors, da diese parallel zur Messkapazität angeordnet sind bzw. wirken. Dadurch wird der Ladungsfluss beim Laden und Entladen erhöht, so dass der auf die Änderung der Messkapazität zurückgehende Anteil der Ladungsflussänderung bei einer Entfernungsänderung geringer wird. Dies führt zu einer Reduzierung der Empfindlichkeit des Näherungssensors bezüglich der Entfernung des Objekts.

Zum Laden und Entladen wird über die Umschalteinrichtung an der Messkapazität wechselweise ein Ladepotenzial und ein Entladepotenzial angelegt. Ist an die Messkapazität das Ladepotenzial angelegt, muss neben der Messkapazität auch die parasitäre Kapazität, die zwischen dem Eingangsanschluss und dem niedrigen Versorgungspotenzial bzw. dem hohen Versorgungspotential des Analogschalters anliegt, geladen werden.

Um dies zu vermeiden, ist vorgesehen, die Potenziale des hohen und niedrigen Versorgungspotenzials für die Umschalteinrichtung entsprechend dem Schaltbetrieb der Umschalteinrichtung zu variieren, so dass die Umladeströme reduziert werden. Insbesondere können beim Anlegen des Ladepotenzials an den Eingangsanschluss zum Aufladen der Messkapazität die Potenziale der Versorgungsspannung der Umschalteinrichtung, vorzugsweise um die Differenz von Ladepotential und Endladepotential, geändert (angehoben) werden. Dagegen können beim Anlegen des Entladepotenzials an den Eingangsanschluss zum Entladen der Messkapazität die Versorgungspotenziale für die Umschalteinrichtung wieder auf die ursprünglichen Potenzialniveaus geändert (abgesenkt) werden.

Somit liegt über der parasitären Kapazität zwischen dem Eingangsanschluss des Analogschalters, d. h. dem Anschluss, der mit der Messkapazität verbunden ist, und dem niedrigen Versorgungspotenzial und/oder dem hohen Versorgungspotential der Umschalteinrichtung, unabhängig vom Schaltzustand, eine verringerte Spannung an, die einen verringerten Umladestrom bewirkt, wenn das Anheben und Absenken der Versorgungspotenziale des Analogschalters synchron zu dem Umschalten durch den Ladezustand und Entladezustand der Messkapazität erfolgt.

Durch das Anheben und Absenken des niedrigen Versorgungspotenzials und des hohen Versorgungspotentials der Schalteinrichtung im Gleichtakt mit dem Umschalten zwischen Ladephase und Entladephase wird die Wirkung der parasitären Kapazitäten weitestgehend eliminiert, da sich eine Änderung der Spannung über den parasitären Kapazitäten reduziert oder die Änderung vollständig unterbunden wird. Dadurch wird der Stromfluss durch die parasitäre Kapazität verringert oder eliminiert und geht bei der Wandlung in eine Ausgangsspannung durch den nachgeschalteten Wandler, der den Lade- und/oder Entladestrom aus der Messkapazität in eine Sensorausgangsspannung wandelt, nicht mehr oder nur in verringertem Maße ein.

Weiterhin kann die aktive Umschalteinrichtung eine aktive elektronische Schaltung aufweisen, die mit Transistoren, insbesondere Feldeffekttransistoren, ausgebildet ist und insbesondere als Analogschalter ausgebildet ist. Die Umschalteinrichtung kann mit zwei einzelnen Schaltern, die wechselweise geschaltet werden, oder mit einem Umschalter-Analogschalter realisiert sein.

Gemäß einer Ausführungsform kann eines der Schalterversorgungspotenziale oder ein von einem der Schalterversorgungspotenziale abgeleitetes Signal zum Steuern der Umschalteinrichtung verwendet werden.

Es kann vorgesehen sein, dass die Ladeschaltung eine Ladekapazität und einen ersten Transimpedanzverstärker aufweist, der ausgebildet ist, ein Ladepotenzial zum Aufladen der Messkapazität zumindest während der Ladephase bereitzustellen und die entsprechende Ausgangsspannung abhängig von einem Ladestrom in die Messkapazität bereitzustellen und/oder wobei die Entladeschaltung eine Entladekapazität und einen zweiten Transimpedanzverstärker aufweist, der ausgebildet ist, ein Entladepotenzial zum Entladen der Messkapazität zumindest während der Entladephase bereitzustellen und die entsprechende Ausgangsspannung abhängig von einem Entladestrom aus der Messkapazität bereitzustellen.

Insbesondere kann die Lade- und Entladekapazität jeweils einen Wert haben, der größer ist als die typischen Kapazitätswerte der Messkapazität, insbesondere weisen die Lade- und Entladekapazität den mindestens zehnfachen Kapazitätswert der Messkapazität bei größtmöglicher Annäherung des Objekts an die Sonde auf.

Weiterhin kann die Schalterversorgungsspannungsquelle mit der Ladeschaltung und/oder der Entladeschaltung verbunden sein, um diese mit den Schalterversorgungspotentialen mit elektrischer Energie zu versorgen.

Gemäß einer Ausführungsform kann die Ladekapazität das Ladepotenzial bezüglich eines Schalterversorgungspotenzials und/oder die Entladekapazität das Entladepotenzial bezüglich des Schalterversorgungspotenzials bereitstellen.

Weiterhin kann ein Vorschalt-Widerstand in Reihe mit der Sonde geschaltet sein. Dadurch wird der Strom in die oder aus der Messkapazität begrenzt, so dass die Umladezeit der Messkapazität beim zyklischen Umschalten durch die Umschalteinrichtung erhöht wird. Dies hat den Vorteil, dass Stromspitzen beim zyklischen Umschalten des Näherungssensors vermieden werden können.

Ferner kann das Ladepotenzial und/oder das Entladepotenzial abhängig von dem Schalterversorgungspotenzial erzeugt werden.

Es kann eine Referenzpotenzialquelle vorgesehen sein, die zyklisch zwischen zwei Potenzialpegeln wechselt, wobei das Schalterversorgungspotenzial und/oder das Ladepotenzial und/oder das Entladepotential abhängig von dem Referenzpotenzial oder mithilfe des Referenzpotenzials erzeugt wird.

Insbesondere kann das Lade- und das Entladepotenzial zwischen dem positiven und negativen Schalterversorgungspotenzial liegen.

Gemäß einer Ausführungsform kann ein Signalverzögerungselement vorgesehen sein, um eine Schaltverzögerung der Umschalteinrichtung zu berücksichtigen.

Gemäß einem weiteren Aspekt ist ein Näherungsschalter mit dem obigen Näherungssensor und einem damit verbundenen Komparator vorgesehen, der eine Schaltschwelle vorgibt, so dass abhängig von einem Überschreiten der Schaltschwelle durch die Sensorausgangsspannung ein Vorhandensein oder Nichtvorhandensein des Objekts signalisierbar ist.

Kurzbeschreibung der Zeichnungen

Ausführungsformen werden nachfolgend anhand der beigefügten Zeichnungen näher erläutert. Es zeigen:

Figur 1    eine schematische Darstellung eines Sensorsystems mit einem Näherungsschalter;

Figur 2    ein Schaltbild eines Näherungssensors mit einer aktiven Schalteinrichtung gemäß einer ersten Ausführungsform;

Figur 3    ein Schaltbild eines Näherungssensors gemäß einer weiteren Ausführungsform;

Figur 4    ein Schaltbild eines Näherungssensors gemäß einer weiteren Ausführungsform.

Beschreibung von Ausführungsformen

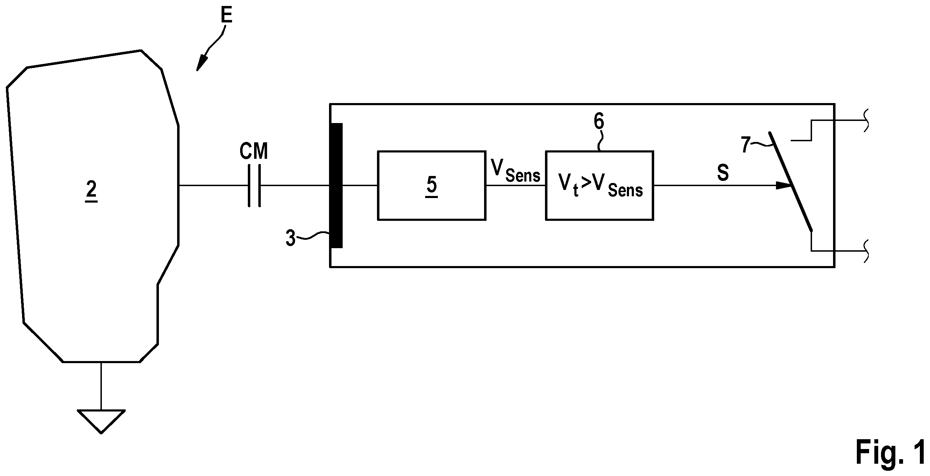

Figur 1 zeigt eine schematische Darstellung eines Näherungsschalters 1 zur Detektion eines leitfähigen, vorzugsweise geerdeten Objekts 2 innerhalb eines Erfassungsbereichs E mit einer elektrisch leitfähigen Sonde 3. Die Sonde 3 ist mit einem Näherungssensor 5 gekoppelt, der eine Sensorausgangsspannung $V_{Sens}$ in Bezug auf das im Erfassungsbereich E befindliche Objekt 2 und dessen Abstand von der Sonde 3 ausgibt.

Der Ausgang der Näherungssensors 5 kann mit einem Komparator 6 gekoppelt sein, der eine Schaltschwelle Vt vorgibt. Je nach Überschreiten der Schaltschwelle Vt durch die Sensorausgangsspannung $V_{Sens}$ kann ein Vorhandensein oder Nichtvorhandensein des Objekts 2 in einem durch die Schaltschwelle Vt vorgegebenen Umgebungsbereich durch ein Schaltsignal S signalisiert werden. Das Schaltsignal S dient zum Ansteuern eines Schalters 7, um einen Stromkreis abhängig von dem Schaltsignal zu schließen oder zu unterbrechen.

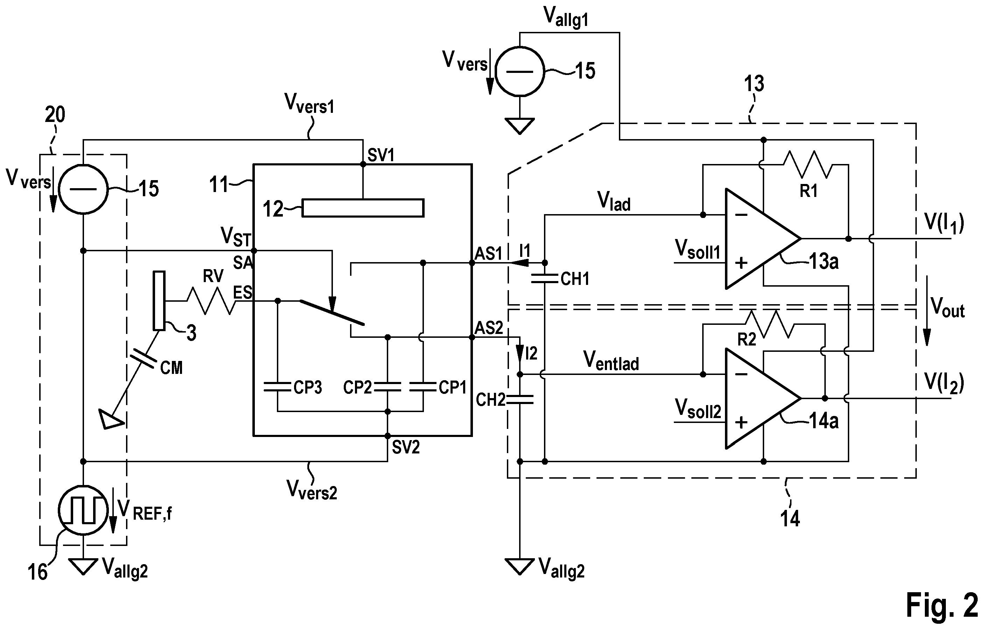

Der Näherungssensor 5 ist als Schaltbild in Figur 2 dargestellt. Dieser umfasst im Wesentlichen eine aktive Umschalteinrichtung 11 sowie eine Ladepotenzialeinheit und eine Entladepotenzialeinheit. Der Näherungssensor 5 arbeitet im Switched Capacitor-Betrieb, bei dem Lade- und/oder Entladeströme in eine und/oder aus einer Messkapazität, die sich zwischen der Sonde 3 und dem Objekt 2 einstellt, gemessen werden. Der daraus resultierende Lade- und/oder Entladestrom entspricht dabei einem Maß für die Größe der Messkapazität, die repräsentativ für den Abstand des Objekts von der Sonde ist.

Die aktive Umschalteinrichtung 11 ist beispielsweise als Analogschalter ausgebildet. Ein Analogschalter stellt einen integrierten Baustein dar, der einen Eingangsanschluss ES schaltbar mit einem von mehreren Ausgangsanschlüssen AS1, AS2 verbindet. Im vorliegenden Fall ist die aktive Umschalteinrichtung 11 in Form eines Umschalters zum Verbinden des Eingangsanschlusses ES mit einem von zwei Ausgangsanschlüssen AS1, AS2 ausgebildet. Ferner weist die aktive Schalteinrichtung 11 einen ersten und einen zweiten Versorgungspotenzialanschluss SV1, SV2 zum Anlegen eines hohen bzw. eines niedrigen Schalterversorgungspotenzials $V_{vers1}$, $V_{vers2}$ auf. Die Schaltstellung der Umschalteinrichtung 11 wird abhängig von einem Pegel an einem Steueranschluss SA eingestellt.

Die aktive Umschalteinrichtung 11 weist eine aktive elektronische Schaltung 11a auf, die mit Transistoren, insbesondere Feldeffekttransistoren, ausgebildet ist. Die aktive Schaltung 11a wird über die Versorgungspotenzialanschlüsse SV1, SV2 durch das hohe Schalterversorgungspotenzial $V_{vers1}$ und das niedrige Schalterversorgungspotenzial $V_{vers2}$ mit einer Schalterversorgungsspannung mit elektrischer Energie versorgt. Das hohe Schalterversorgungspotenzial $V_{vers1}$ und das niedrige Schalterversorgungspotenzial $V_{vers2}$ werden von einer Schalterversorgungsspannungsquelle 20 bereitgestellt. Auf den konkreten Aufbau der aktiven Schaltung 11a der Umschalteinrichtung 11 soll hierin nicht näher eingegangen werden.

Jedoch steht die aktive Schaltung 11a der Umschalteinrichtung 11 mit dem Eingangsanschluss ES und den Ausgangsanschlüssen AS1, AS2 so in Verbindung, dass zwischen diesen Anschlüssen ES, AS1, AS2 und dem zweiten Versorgungspotenzialanschluss SV2 parasitäre Kapazitäten CP1, CP2, CP3 wirken. Weitere parasitäre Kapazitäten liegen zwischen den Anschlüssen ES, AS1, AS2 und dem ersten Versorgungspotenzialanschluss SV1 an. Die Auswirkung dieser weiteren parasitären Kapazitäten ist identisch zu den oben genannten parasitären Kapazitäten bezüglich des zweiten Versorgungspotenzialanschlusses SV2. Zur Vereinfachung sind die weiteren parasitären Kapazitäten in den Figuren nicht gezeichnet.

Der erste Ausgangsanschluss AS1 der aktiven Umschalteinrichtung 11 ist mit einem ersten Anschluss einer Ladekapazität CH1 verbunden, und an einen zweiten Anschluss der Ladekapazität CH1 ist ein niedriges Versorgungspotenzial $V_{allg2}$ angelegt. Der zweite Ausgangsanschluss AS2 der aktiven Umschalteinrichtung 11 ist mit einem ersten Anschluss einer Entladekapazität CH2 verbunden, und an einen zweiten Anschluss der Entladekapazität CH2 ist das niedrige Versorgungspotenzial $V_{allg2}$ angelegt.

Die Lade- und Entladekapazität CH1, CH2 besitzen jeweils einen Wert, der deutlich größer ist als die typischen Werte der Messkapazität CM bei größtmöglicher Annäherung des Objekts an die Sonde 3. Insbesondere weisen die Lade- und Entladekapazität CH1, CH2 die mindestens zehnfache Kapazität der Messkapazität CM auf.

Der Näherungssensor 5 wird zyklisch betrieben. Dazu wird die aktive Umschalteinrichtung 11 entsprechend einer Zyklusfrequenz f wechselweise umgeschaltet. Die Zyklusfrequenz f liegt üblicherweise im Bereich von einigen Zehn kHz, insbesondere 50 kHz, bis einigen MHz, wie z.B. bis 10 MHz. Dazu wird ein zyklisch variierendes Steuerpotenzial $V_{ST}$ an den Steueranschluss der Umschalteinrichtung 11 angelegt.

Der erste Ausgangsanschluss AS1 ist ferner mit einer Ladeschaltung 13 verbunden, die vorzugsweise mit einem ersten Transimpedanzverstärker 13a ausgebildet ist. Der erste Transimpedanzverstärker 13a ermöglicht das Bereitstellen einer Ladespannung $V_{lad}$. Die Ladespannung $V_{lad}$ liegt an einer Ladekapazität CH1 an, die die zyklischen Ladevorgänge puffert. Zudem kann beim Schalten der Messkapazität $C_M$ auf den ersten Ausgangsanschluss AS1 die Messkapazität $C_M$ durch die Ladekapazität CH1 geladen werden. Der erste Transimpedanzverstärker 13a wandelt diesen Ladestrom I1 in eine entsprechende davon abhängige Ausgangsspannung um.

Der erste Transimpedanzverstärker 13a kann einen Operationsverstärker aufweisen, an dessen nichtinvertierenden Anschluss der Sollwert $V_{soll1}$ der Ladespannung $V_{lad}$ angelegt ist. Diese kann beispielsweise durch einen Spannungsteiler erzeugt werden. Der invertierende Anschluss des Operationsverstärkers ist mit dem ersten Ausgangsanschluss AS1 verbunden. Zwischen dem Ausgang des Operationsverstärkers und dem invertierenden Anschluss ist ein Widerstand R1 geschaltet. Mit R1 wird der Faktor eingestellt, mit dem der Ladestrom in die Ausgangsspannung V(I1) gewandelt wird.

Der zweite Ausgangsanschluss AS2 ist ferner mit einer Entladeschaltung 14 verbunden, die vorzugsweise mit einem zweiten Transimpedanzverstärker 14a ausgebildet ist, der ein Entladepotenzial $V_{entlad}$ bereitstellt. Dadurch kann beim Schalten der Messkapazität $C_M$ auf den zweiten Ausgangsanschluss AS2 die Messkapazität $C_M$ in die Entladekapazität CH2 entladen werden, so dass am Ausgang des zweiten Transimpedanzverstärkers 14a eine von dem Entladestrom I2 abhängige Spannung anliegt.

Der zweite Transimpedanzverstärker 14a kann einen Operationsverstärker aufweisen, an dessen nicht-invertierenden Anschluss ein Sollwert $V_{soll2}$ des Entladepotenzials $V_{entlad}$ angelegt ist. Der invertierende Anschluss des Operationsverstärkers ist mit dem zweiten Ausgangsanschluss AS1 verbunden. Zwischen dem Ausgang des Operationsverstärkers und dem invertierenden Anschluss ist ein Widerstand R2 geschaltet. Mit dem Widerstand R2 wird der Faktor eingestellt, mit dem der Entladestrom in die Ausgangsspannung V(I2) gewandelt wird.

Die Operationsverstärker der Transimpedanzverstärker 13a,14a sind über das hohe Versorgungspotenzial $V_{allg1}$ und das niedrige Versorgungspotenzial $V_{allg2}$ mit elektrischer Energie versorgt.

Bei dem vorliegenden Näherungssensor 5 ergibt sich als Sensorausgangsspannung Vout (kann $V_{Sens}$ entsprechen) eine Spannungsdifferenz zwischen den Ausgängen V(I1)-V(I2) der Transimpedanzverstärker 13a, 14a abhängig von der Höhe des Ladestroms I1 und des Entladestroms I2. Der Ladestrom entspricht $I1 = V_{lad} \times C_M \times f$. Der Entladestrom entspricht $I2 = --V_{entlad} \times C_M \times f$. Durch Differenzbildung der Ausgangsspannungen der Transimpedanzverstärker 13a, 14a kann somit die Empfindlichkeit bezüglich der Änderung der Messkapazität verbessert werden.

Durch den Einsatz der Transimpedanzverstärker 13a, 14a wird die Lade- und Entladekapazität CH1, CH2 jeweils auf Spannungspotenzialen gehalten, die durch den Transimpedanzverstärker vorgegeben werden. So legt der erste Transimpedanzverstärker 13a die Ladespannung $V_{lad}$ an die Ladekapazität CH1 an und hält diesen auch während der Ladephase auf diesem Spannungsniveau. Gleichermaßen hält der zweite Transimpedanzverstärker 14a das Spannungsniveau am zweiten Entladekapazität CH2 auf dem Entladepotenzial $V_{entlad}$ und hält diesen auch während der Entladephase.

Die Transimpedanzverstärker 13a, 14a sind für die Anwendung in einem solchen Näherungssensor 5 besonders geeignet, da sie zum einen ein Lade- und Entladepotenzial vorgeben können und andererseits eine Ausgangsspannung bereitstellen können, die zu einem Stromfluss in bzw. aus der Messkapazität proportional ist.

Erfindungsgemäß ist vorgesehen, die Schalterversorgungspotenziale $V_{vers1}$, $V_{vers2}$ mithilfe eines Rechtecksignals $V_{REF,f}$ zu erzeugen, so dass die Schalterversorgungspotenziale $V_{vers1}$, $V_{vers2}$ entsprechend dem Schaltzyklus angehoben oder abgesenkt werden. Der Schaltzyklus kann durch ein Steuersignal vorgegeben werden. Zur Ansteuerung der Umschalteinrichtung 11 kann das Rechtecksignal $V_{REF,f}$ dem Steuerpotenzial $V_{ST}$ entsprechen oder von diesem abweichen. Alternativ kann das Rechtecksignal auch abhängig von einem vorgegebenen Steuerpotenzial zur Ansteuerung der Umschalteinrichtung 11 generiert werden.

Das Verbinden des Eingangsanschlusses ES mit dem ersten Ausgangsanschluss AS1 kann bei einem hohen Potenzial des Steuerpotenzials $V_{ST}$ und das Verbinden des Eingangsanschlusses ES mit dem zweiten Ausgangsanschluss AS2 bei einem niedrigen Potenzial des Steuerpotenzials erfolgen. Das niedrige Schalterversorgungspotenzial $V_{vers2}$ wird vorzugsweise zyklisch zwischen 0V und $V_{REF,f}$ angehoben und wieder abgesenkt.

Das Anheben und Absenken der Schalterversorgungspotenziale $V_{vers1}$, $V_{vers2}$ synchron zum Umschalten zwischen der Ladephase und Entladephase ermöglicht es, den Einfluss der parasitären Kapazitäten in der Umschalteinrichtung 11 erheblich zu reduzieren, da diese nicht oder in verringertem Maße durch den Ladestrom I1 oder Entladestrom I2 umgeladen werden müssen. Dies hat den Vorteil, dass die effektive Messkapazität nicht oder nur in verringertem Maße durch die parasitären Kapazitäten vergrößert wird, so dass die Empfindlichkeit des Näherungssensors 5 nur in reduziertem Maße durch die parasitären Kapazitäten CP1, CP2, CP3 der Umschalteinrichtung 11 beeinträchtigt wird.

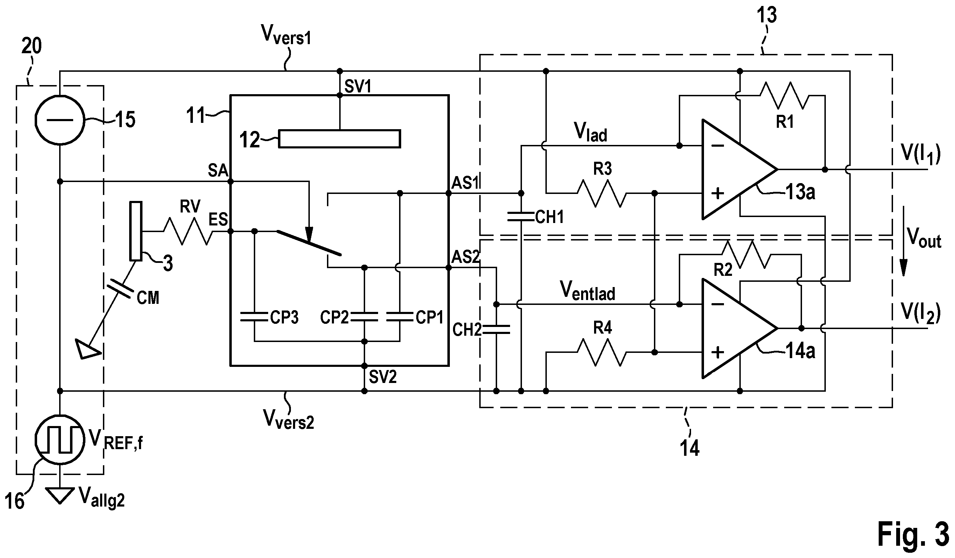

Wie in Figur 3 dargestellt, können zusätzlich zu den Schalterversorgungspotenzialen $V_{vers1}$, $V_{vers2}$ auch die Versorgungspotenziale $V_{allg1}$, $V_{allg2}$ (Bezugszeichen $V_{allg1}$ daher nicht mehr in Figur 3 dargestellt) der Transimpedanzverstärker 13, 14 bzw. der Operationsverstärker mit den zyklisch geschalteten Schalterversorgungspotenzialen $V_{vers1}$, $V_{vers2}$ mit elektrischer Energie versorgt werden. Dadurch kann erreicht werden, dass die Transimpedanzverstärker 13a, 14a ausgangsseitig im Wesentlichen Gleichspannungen bezogen auf die Versorgungspotenziale $V_{vers1}$, $V_{vers2}$ ausgeben.

Weiterhin können an die nicht mit den Ausgangsanschlüssen der Umschalteinrichtung 11 verbundenen Anschlüsse der Lade- und Entladekapazitäten CH1, CH2 das niedrige oder das hohe Schalterversorgungspotenzial angelegt sein.

Zudem kann, wie in der Ausführungsform der Figur 3 dargestellt, ein Vorschalt-Widerstand RV in Reihe mit der Messkapazität $C_M$ vorgesehen werden. Dadurch wird der Strom aus der Messkapazität $C_M$ begrenzt, so dass die Umladezeit der Messkapazität $C_M$ beim zyklischen Umschalten durch die Umschalteinrichtung 11 erhöht wird. Der Widerstand RV kann in Bezug auf die Schaltfrequenz der Umschalteinrichtung 11 so dimensioniert sein, dass die Messkapazität $C_M$ innerhalb

$$T = \frac{1}{2f}$$ im Wesentlichen umgeladen wird. Dies hat den Vorteil, dass Stromspitzen beim zyklischen Umschalten des Näherungssensors 5 vermieden werden, was insbesondere Vorteile hinsichtlich des EMV-Verhaltens der Schaltung des Näherungssensors 5 hat.

Das zyklische Anheben und Absenken der Versorgungspotenziale $V_{allg1}$, $V_{allg2}$ kann durch Beaufschlagen einer Versorgungsspannungsquelle 15 mit einem Rechteckspannungssignal $V_{REF,f}$ einer Referenzspannungsquelle 16 erfolgen. Dieses Rechteckspannungssignal $V_{REF,f}$ kann als Steuerpotenzial für die Umschalteinrichtung 11 verwendet werden und gleichzeitig die Versorgungspotenziale $V_{allg1}$, $V_{allg2}$ entsprechend anheben und absenken, um die Schalterversorgungspotenziale $V_{vers1}$, $V_{vers2}$ zu erzeugen. Gleichzeitig kann das Ladepotenzial $V_{lad}$ und das Entladepotenzial $V_{entlad}$ in entsprechender Weise angehoben bzw. abgesenkt werden, indem diese mit der Referenzspannungsquelle 16 beaufschlagt werden. Das Ladepotenzial $V_{lad}$ und das Entladepotenzial $V_{entlad}$ können identisch oder voneinander verschieden sein. Somit wird der Sollwert $V_{soll1}$ für das Ladepotenzial $V_{lad}$ erzeugt, indem das Versorgungsspannungspotential $V_{vers2}$ um ein vorgegebenes Offsetpotenzial $V_{offset}$ angehoben wird, welches wiederum in der Ladephase durch die Referenzspannungsquelle 16 angehoben wird, wenn die Messkapazität mit der Ladekapazität CH1 verbunden wird. Wenn in der Entladephase die Messkapazität $C_M$ mit der Entladekapazität CH2 verbunden wird, kann das Entladepotenzial am nicht-invertierenden Anschluss des Operationsverstärkers des zweiten Transimpedanzverstärkers 14a durch das Absenken des Rechteckspannungssignals der Referenzspannungsquelle 16 auf 0V lediglich dem Offsetpotenzial $V_{offset}$ entsprechen. Das Offsetpotenzial $V_{offset}$ kann mithilfe des Spannungsteilers der Widerstände R3, R4 für beide Transimpedanzverstärker 13a, 14a bereitgestellt werden. Somit wird der Sollwert $V_{soll2}$ für das Entladepotenzial $V_{entlad}$ in gleicher Weise wie der Sollwert $V_{soll1}$ für das Ladepotenzial $V_{lad}$ erzeugt.

Mit dem Anheben und Senken der Schalterversorgungspotenziale $V_{vers1}$, $V_{vers2}$ werden auch die Potenziale der parasitären Kapazitäten CP2 und CP3 angehoben und gesenkt. Bei jedem Anheben und Absenken fließt ein Strom zwischen der parasitären Kapazität CP2 und der Entladekapazität CH2 sowie zwischen der parasitären Kapazität CP3 und der Entladekapazität CH2. Diese Ströme können vermieden werden, indem die Haltekapazitäten CH1 und CH2 auf die sich hebenden und senkenden Versorgungspotenziale der Umschalteinrichtung 11 bezogen werden.

Um zu gewährleisten, dass die Transimpedanzverstärker 13a, 14a positiv und negativ ansteuerbar sind, sollten die Potentiale an den nicht invertierenden Anschlüssen zwischen deren hohen und niedrigen Schalterversorgungspotenzialen $V_{vers1}$, $V_{vers2}$ liegen. Dies kann beispielsweise mit dem Spannungsteiler, gebildet aus den Widerständen R3 und R4, erreicht werden, der zwischen den hohen und niedrigen Schalterversorgungspotenzialen der Transimpedanzverstärker 13a, 14a geschaltet ist. Werden das hohe und niedrige Schalterversorgungspotenzial an die Transimpedanzverstärker 13a, 14a angelegt, so hebt und senkt sich das entsprechende Ladepotenzial $V_{lad}$ und Entladepotenzial $V_{entlad}$ entsprechend um den durch das Rechtecksignal $V_{REF,f}$ der Referenzspannungsquelle 16 vorgegebenen Spannungshub.

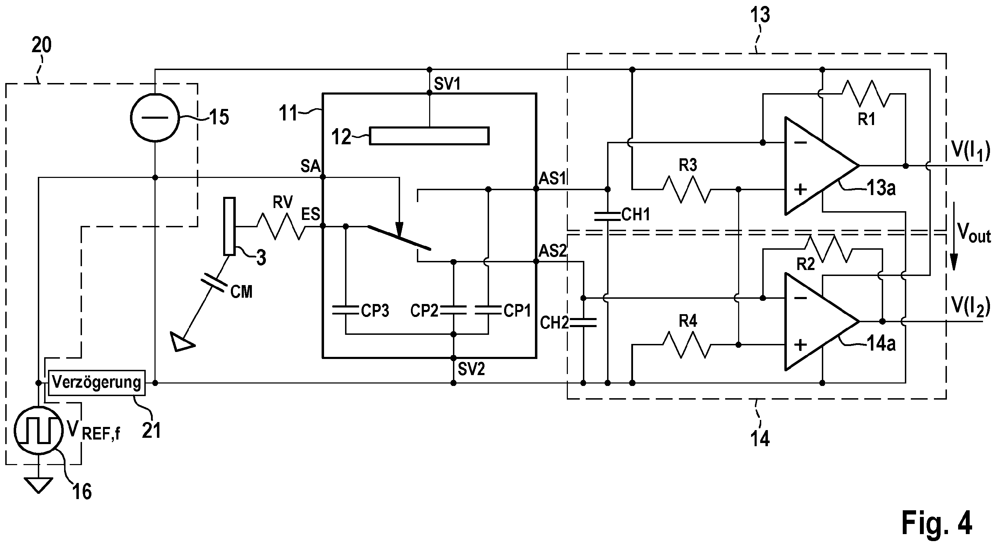

Mit Bezug auf die Ausführungsform, die in dem Schaltbild der Figur 4 dargestellt ist, kann ein Signalverzögerungselement 21 vorgesehen sein, um eine Schaltverzögerung der Umschalteinrichtung 11 zu berücksichtigen. Dadurch kann zwischen dem Signalisieren eines Umschaltens zwischen der Ladephase und der Entladephase und dem Vorsehen des zyklischen Potenzialwechsels des Schalterversorgungspotenziale $V_{vers1}$, $V_{vers2}$ vollständigen Umschalten der Umschalteinrichtung 11 eine Zeitverzögerung vorgesehen werden.

Bezugszeichenliste

| 1 | Näherungsschalter |
|---|---|
| 2 | Objekt |
| 3 | Sonde |
| 5 | Näherungssensor |
| 6 | Komparator |
| 7 | Schalter |
| 11 | aktive Umschalteinrichtung |
| 12 | aktive elektronische Schaltung |
| 13 | Ladeschaltung |
| 13a | erster Transimpedanzverstärker |
| 14 | Entladeschaltung |
| 14a | zweiter Transimpedanzverstärker |
| 15 | Versorgungsspannungsquelle |
| 16 | Referenzspannungsquelle |
| 20 | Schalterversorgungsspannungsquelle |
| 21 | Signalverzögerungselement |
| Vt | Schaltschwelle |
| $V_{Sens}$, $V_{out}$ | Sensorausgangsspannung |
| ES | Eingangsanschluss |
| AS1, AS2 | Ausgangsanschlüssen |
| SV1, SV2 | erster und zweiter Versorgungspotenzialanschluss |
| $V_{vers1}$, $V_{vers2}$ | hohes bzw. niedriges Schalterversorgungspotenzial |
| SA | Steueranschluss |
| CP1, CP2, CP3 | parasitäre Kapazitäten |
| CH1, CH2 | Lade- und Entladekapazität |
| CM | Messkapazität |
| R1- R4 | Widerstände |
| $V_{REF,f}$ | Rechtecksignal |
| $V_{ST}$ | Steuerpotenzial |
| $V_{allg1}$, $V_{allg2}$ | hohes und niedriges Versorgungspotential |
| $V_{offset}$ | Offsetpotenzial |
| I1 | Ladestrom |
| I2 | Entladestrom |

**Patentansprüche**

1. Kapazitiver Näherungssensor (5) zur Detektion eines Objekts (2) innerhalb eines Erfassungsbereichs (E) und zum Bereitstellen einer Sensorausgangsspannung ($V_{Sens}$, $V_{out}$), umfassend:

- eine elektrisch leitfähige Sonde (3);
- eine Ladeschaltung (13) zum zyklischen Laden einer sich an der Sonde (3) einstellenden Messkapazität (CM) während einer Ladephase auf ein Ladepotenzial ($V_{lad}$) und eine Entladeschaltung (14) zum zyklischen Entladen der sich an der Sonde (3) einstellenden Messkapazität (CM ) während einer Entladephase auf ein Entladepotenzial ($V_{entlad}$), wobei die Ladeschaltung (13) und die Entladeschaltung (14) ausgebildet sind, um eine erste Ausgangsspannung ( V(I1) ) abhängig von einem Ladestrom (I1) in die Messkapazität (CM) und eine zweite Ausgangsspannung ( V(I2) ) abhängig von einem Entladestrom (I2) aus der Messkapazität (CM) bereitzustellen, wobei die Sensorausgangsspannung ($V_{Sens}$) abhängig von der ersten und der zweiten Ausgangsspannung ( V(I1), V(I2) ) bereitgestellt wird;
- eine aktive Umschalteinrichtung (11) zum wechselweisen elektrischen Verbinden der Sonde (3) mit der Ladeschaltung (13) und der Entladeschaltung (14);
- eine Schalterversorgungsspannungsquelle (20), die ausgebildet ist, um Schalterversorgungspotenziale ($V_{vers1}$, $V_{vers2}$) zur elektrischen Versorgung der aktiven Umschalteinrichtung (11) synchron zum Umschalten zwischen der Ladephase und Entladephase zyklisch umzuschalten.

2. Näherungssensor (5) nach Anspruch 1, wobei die aktive Umschalteinrichtung (11) eine aktive elektronische Schaltung (12) aufweist, die mit Transistoren, insbesondere Feldeffekttransistoren, ausgebildet ist und insbesondere als Analogschalter ausgebildet ist.

3. Näherungssensor (5) nach einem der Ansprüche 1 bis 2, wobei eines der Schalterversorgungspotenziale ($V_{vers1}$, $V_{vers2}$) oder ein von einem der Schalterversorgungspotenziale ($V_{vers1}$, $V_{vers2}$) abgeleitetes Signal ($V_{ST}$) zum Steuern der Umschalteinrichtung (11) verwendet wird.

4. Näherungssensor (5) nach einem der Ansprüche 1 bis 3, wobei die Ladeschaltung (13) eine Ladekapazität (CH1) und einen ersten Transimpedanzverstärker (13a) aufweist, der ausgebildet ist, ein Ladepotenzial ($V_{lad}$) zum Aufladen der Messkapazität (CM) zumindest während der Ladephase bereitzustellen und die entsprechende erste Ausgangsspannung (V(I1)) abhängig von einem Ladestrom (I1) in die Messkapazität (CM) bereitzustellen und wobei die Entladeschaltung (14) eine Entladekapazität (CH2) und einen zweiten Transimpedanzverstärker (14a) aufweist, der ausgebildet ist, ein Entladepotenzial ($V_{entlad}$) zum Entladen der Messkapazität (CM) zumindest während der Entladephase bereitzustellen und die entsprechende zweite Ausgangsspannung ( V(I2) )abhängig von einem Entladestrom (I2) aus der Messkapazität (CM) bereitzustellen.

5. Näherungssensor (5) nach Anspruch 4, wobei die Lade- und Entladekapazität (CH1, CH2) jeweils einen Wert haben, der größer ist als die typischen Kapazitätswerte der Messkapazität (CM) bei größtmöglicher Annäherung der Sonde an das Objekt (2), wobei insbesondere die Lade- und Entladekapazität (CH1, CH2) den mindestens zehnfachen Kapazitätswert der Messkapazität (CM) aufweisen.

6. Näherungssensor (5) nach einem der Ansprüche 3 bis 5, wobei die Schalterversorgungspannungsquelle (20) mit der Ladeschaltung (13) und/oder der Entladeschaltung (14) verbunden ist, um diese mit den Schalterversorgungspotentialen ($V_{vers1}$, $V_{vers2}$) mit elektrischer Energie zu versorgen.

7. Näherungssensor (5) nach einem der Ansprüche 4 bis 6, wobei die Ladekapazität (CH1) das Ladepotenzial ($V_{lad}$) bezüglich eines Schalterversorgungspotenzials ($V_{vers1}$, $V_{vers2}$) bereitstellt.

8. Näherungssensor (5) nach einem der Ansprüche 1 bis 7, wobei ein Vorschalt-Widerstand (RV) in Reihe mit der Sonde (3) geschaltet ist.

9. Näherungssensor nach einem der Ansprüche 1 bis 8, wobei das Ladepotenzial ($V_{lad}$) und/oder das Entladepotenzial ($V_{entlad}$) abhängig von dem Schalterversorgungspotenzial ($V_{vers1}$, $V_{vers2}$) erzeugt wird.

10. Näherungssensor nach einem der Ansprüche 1 bis 9, wobei eine Referenzpotenzialquelle (16) vorgesehen ist, die zyklisch zwischen zwei Potenzialpegeln wechselt, wobei das Schalterversorgungspotenzial ($V_{vers1}$, $V_{vers2}$) und/oder das Ladepotenzial ($V_{lad}$) und/oder das Entladepotential ($V_{entlad}$) abhängig vom Potential der Referenzpotenzialquelle (16) oder mithilfe der Referenzpotenzialquelle (16) erzeugt wird.

11. Näherungssensor (5) nach Anspruch 10, wobei das Lade- und das Entladepotenzial ($V_{lad}$, $V_{entlad}$) zwischen dem positiven und negativen Schalterversorgungspotenzial ($V_{vers1}$, $V_{vers2}$) liegen.

12. Näherungssensor (5) nach einem der Ansprüche 1 bis 11, wobei ein Signalverzögerungselement vorgesehen ist, um eine Schaltverzögerung der Umschalteinrichtung (11) zu berücksichtigen.

13. Näherungsschalter (1) mit einem Näherungssensor nach einem der Ansprüche 1 bis 12 und einem damit verbundenen Komparator, der eine Schaltschwelle ($V_t$) vorgibt, so dass abhängig von einem Überschreiten der Schaltschwelle ($V_t$) durch die Sensorausgangsspannung ($V_{Sens}$) ein Vorhandensein oder Nichtvorhandensein des Objekts (2) signalisierbar ist.

## Claims

1. Capacitive proximity sensor (5) for detecting an object (2) within a detection range (E) and for providing a sensor output voltage ($V_{Sens}$, $V_{out}$), comprising:

    - an electrically conductive probe (3);
    - a charging circuit (13) for cyclically charging a measuring capacitance (CM) established at the probe (3) to a charging potential ($V_{lad}$) during a charging phase, and a discharging circuit (14) for cyclically discharging the measuring capacitance (CM) established at the probe (3) (CM ) during a discharge phase to a discharge potential ($V_{entlad}$), wherein the charging circuit (13) and the discharging circuit (14) are designed to provide a first output voltage ( V(I1) ) dependent on a charging current (11) in the measuring capacitance (CM) and a second output voltage ( V(I2) ) dependent on a discharge current (I2) from the measuring capacitance (CM), wherein the sensor output voltage ($V_{Sens}$) is provided dependent on the first and second output voltages ( V(I1), V(I2) );
    - an active switching device (11) for alternately electrically connecting the probe (3) to the charging circuit (13) and the discharging circuit (14);
    - a switch supply voltage source (20) which is designed to switch switch supply potentials ($V_{vers1}$, $V_{vers2}$) for the electrical supply of the active switching device (11) cyclically in synchronism with the switching between the charging phase and the discharging phase.

2. Proximity sensor (5) according to claim 1, wherein the active switching device (11) has an active electronic circuit (12) which is designed with transistors, in particular field-effect transistors, and is designed in particular as an analog switch.

3. Proximity sensor (5) according to one of claims 1 to 2, wherein one of the switch supply potentials ($V_{vers1}$, $V_{vers2}$) or a signal ($V_{ST}$) derived from one of the switch supply potentials ($V_{vers1}$, $V_{vers2}$) is used to control the switching device (11).

4. Proximity sensor (5) according to one of claims 1 to 3, wherein the charging circuit (13) has a charging capacitance (CH1) and a first transimpedance amplifier (13a) which is designed to provide a charging potential ($V_{lad}$) for charging the measuring capacitance (CM) at least during the charging phase and to supply the corresponding first output voltage (V(I1)) to the measuring capacitance (CM) as a function of a charging current (I1), and wherein the discharge circuit (14) has a discharge capacitance (CH2) and a second transimpedance amplifier (14a) which is designed to provide a discharge potential ($V_{entlad}$) for discharging the measuring capacitance (CM) at least during the discharge phase and to provide the corresponding second output voltage ( V(I2) ) from the measuring capacitance (CM) as a function of a discharge current (I2).

5. Proximity sensor (5) according to claim 4, wherein the charging and discharging capacitances (CH1, CH2) each have a value that is greater than the typical capacitance values of the measuring capacitance (CM) when the probe is as close as possible to the object (2), wherein, in particular, the charging and discharging capacities (CH1, CH2) have at least ten times the capacity value of the measuring capacity (CM).

6. Proximity sensor (5) according to one of claims 3 to 5, wherein the switch supply voltage source (20) is connected to the charging circuit (13) and/or the discharging circuit (14) in order to supply these with electrical energy at the switch supply potentials ($V_{vers1}$, $V_{vers2}$).

7. Proximity sensor (5) according to one of claims 4 to 6, wherein the charging capacity (CH1) provides the charging potential ($V_{lad}$) relative to a switch supply potential ($V_{vers1}$, $V_{vers2}$).

8. Proximity sensor (5) according to one of claims 1 to 7, wherein a series resistor (RV) is connected in series with the probe (3).

9. Proximity sensor according to one of claims 1 to 8, wherein the charging potential ($V_{lad}$) and/or the discharging potential ($V_{entlad}$) is generated depending on the switch supply potential ($V_{vers1}$, $V_{vers2}$).

10. Proximity sensor according to one of claims 1 to 9, wherein a reference potential source (16) is provided which cyclically switches between two potential levels, wherein the switch supply potential ($V_{vers1}$, $V_{vers2}$) and/or the charging potential ($V_{lad}$) and/or the discharging potential ($V_{entlad}$) is generated depending on the potential of the reference potential source (16) or with the aid of the reference potential source (16).

11. Proximity sensor (5) according to claim 10, wherein the charging and discharging potentials ($V_{lad}$, $V_{entlad}$) lie between the positive and negative switch supply potentials ($V_{vers1}$, $V_{vers2}$).

12. Proximity sensor (5) according to one of claims 1 to 11, wherein a signal delay element is provided to take into account a switching delay of the switching device (11).

13. Proximity switch (1) with a proximity sensor according to one of claims 1 to 12 and a comparator connected thereto, which specifies a switching threshold ($V_t$) such that, depending on the switching threshold ($V_t$) being exceeded by the sensor output voltage ($V_{Sens}$), the presence or absence of the object (2) can be signaled.

**Revendications**

1. Capteur de proximité capacitif (5) pour détecter un objet (2) à l'intérieur d'une zone de détection (E) et pour fournir une tension de sortie de capteur ($V_{Sens}$, $V_{out}$), comprenant :

   - une sonde électriquement conductrice (3) ;
   - un circuit de charge (13) pour charger cycliquement une capacité de mesure (CM) s'établissant au niveau de la sonde (3) pendant une phase de charge à un potentiel de charge ($V_{lad}$) et un circuit de décharge (14) pour décharger cycliquement la capacité de mesure s'établissant au niveau de la sonde (3) (CM) pendant une phase de décharge, à un potentiel de décharge ($V_{entlad}$), le circuit de charge (13) et le circuit de décharge (14) étant conçus pour fournir une première tension de sortie ( $V(I1)$ ) dépendante d'un courant de charge (I1) dans la capacité de mesure (CM) et une deuxième tension de sortie ( $V(I2)$ ) dépendante d'un courant de décharge (I2) à partir de la capacité de mesure (CM), la tension de sortie du capteur ($V_{Sens}$) étant fournie en fonction de la première et de la deuxième tension de sortie ( $V(I1)$, $V(I2)$ ) ;
   - un dispositif de commutation actif (11) pour connecter électriquement de manière alternée la sonde (3) au circuit de charge (13) et au circuit de décharge (14);
   - une source de tension d'alimentation de commutation (20) qui est conçue pour commuter cycliquement des potentiels d'alimentation de commutation ($V_{vers1}$, $V_{vers2}$) destinés à l'alimentation électrique du dispositif de commutation actif (11) de manière synchrone avec la commutation entre la phase de charge et la phase de décharge.

2. Capteur de proximité (5) selon la revendication 1, dans lequel le dispositif de commutation actif (11) comprend un circuit électronique actif (12) qui est conçu avec des transistors, en particulier des transistors à effet de champ, et qui est notamment conçu comme un commutateur analogique.

3. Capteur de proximité (5) selon l'une des revendications 1 à 2, dans lequel l'un des potentiels d'alimentation des commutateurs ($V_{vers1}$, $V_{vers2}$) ou un signal ($V_{ST}$) dérivé de l'un des potentiels d'alimentation des commutateurs ($V_{vers1}$, $V_{vers2}$) est utilisé pour commander le dispositif de commutation (11).

4. Capteur de proximité (5) selon l'une des revendications 1 à 3, le circuit de charge (13) comportant une capacité de charge (CH1) et un premier amplificateur à transimpédance (13a) qui est conçu pour fournir un potentiel de charge ($V_{lad}$) pour charger la capacité de mesure (CM) au moins pendant la phase de charge et pour fournir la première tension de sortie correspondante ($V(I1)$) en fonction d'un courant de charge (I1) dans la capacité de mesure (CM), et le circuit de décharge (14) comportant une capacité de décharge (CH2) et un deuxième amplificateur à transimpédance (14a) qui est conçu pour fournir un potentiel de décharge ($V_{entlad}$) pour décharger la capacité de mesure (CM) au moins pendant la phase de décharge et pour fournir la deuxième tension de sortie correspondante ( $V(I2)$ ) en fonction d'un courant de décharge (I2) à partir de la capacité de mesure (CM).

5. Capteur de proximité (5) selon la revendication 4, dans lequel les capacités de charge et de décharge (CH1, CH2) ont chacune une valeur supérieure aux valeurs de capacité typiques de la capacité de mesure (CM) lorsque la sonde est aussi proche que possible de l'objet (2), la capacité de charge et de décharge (CH1, CH2) présentant en particulier au moins dix fois la valeur de capacité de la capacité de mesure (CM).

6. Capteur de proximité (5) selon l'une des revendications 3 à 5, la source de tension d'alimentation du commutateur (20) étant reliée au circuit de charge (13) et/ou au circuit de décharge (14) afin d'alimenter ceux-ci en énergie électrique avec les potentiels d'alimentation du commutateur ($V_{vers1}$, $V_{vers2}$).

7. Capteur de proximité (5) selon l'une des revendications 4 à 6, la capacité de charge (CH1) fournissant le potentiel de charge ($V_{lad}$) par rapport à un potentiel d'alimentation du commutateur ($V_{vers1}$, $V_{vers2}$).

8. Capteur de proximité (5) selon l'une des revendications 1 à 7, dans lequel une résistance série (RV) est montée en série avec la sonde (3).

9. Capteur de proximité selon l'une des revendications 1 à 8, le potentiel de charge ($V_{lad}$) et/ou le potentiel de décharge ($V_{entlad}$) étant généré en fonction du potentiel d'alimentation du commutateur ($V_{vers1}$, $V_{vers2}$).

**10.** Capteur de proximité selon l'une des revendications 1 à 9, dans lequel une source de potentiel de référence (16) est prévue, qui alterne cycliquement entre deux niveaux de potentiel, le potentiel d'alimentation du commutateur ($V_{vers1}$, $V_{vers2}$) et/ou le potentiel de charge ($V_{lad}$) et/ou le potentiel de décharge ($V_{entlad}$) en fonction du potentiel de la source de potentiel de référence (16) ou à l'aide de la source de potentiel de référence (16).

**11.** Capteur de proximité (5) selon la revendication 10, dans lequel les potentiels de charge et de décharge ($V_{lad}$, $V_{entlad}$) se situent entre le potentiel d'alimentation positif et négatif du commutateur ($V_{vers1}$, $V_{vers2}$).

**12.** Capteur de proximité (5) selon l'une des revendications 1 à 11, dans lequel un élément de retard de signal est prévu pour tenir compte d'un retard de commutation du dispositif de commutation (11).

**13.** Détecteur de proximité (1) avec un capteur de proximité selon l'une des revendications 1 à 12 et un comparateur qui lui est relié et qui définit un seuil de commutation ($V_t$) de telle sorte que, en fonction du dépassement du seuil de commutation ($V_t$) par la tension de sortie du capteur ($V_{Sens}$), la présence ou l'absence de l'objet (2) peut être signalée.

Fig. 1

EP 4 122 100 B1

Fig. 2

EP 4 122 100 B1

Fig. 3

EP 4 122 100 B1

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0226082 A1
- EP 2642663 A1

- EP 0908736 A2